# DEMANDE DE BREVET EUROPEEN

(11) **EP 0 944 168 A1**
(43) Date de publication de la demande: **22.09.1999**
(21) Numéro de dépôt: 99400373.9
(22) Date de dépôt: 17.02.1999
(51) Int. Cl.: H03J 9/00

(54) **Procédé de transmission d'une commande d'un dispositif de commande à distance vers un appareil audio, dispositif de commande à distance et appareil audio correspondants**

(30) Priorité: 09.03.1998 FR 9802823
(71) Demandeur: ALCATEL, 75008 Paris (FR)
(72) Inventeur: Attimont, Luc, 78560 Le Port Marly. (FR); Bodin, Jannick, 92380 Garches (FR)
(74) Mandataire: Feray, Valérie

(57) **Abrégé**

L'invention concerne la transmission d'une commande d'un dispositif de commande à distance (1) vers un appareil audio (2). L'appareil audio échange, sur un médium (5), au moins un signal audio (17) avec un accessoire audio (3). Le dispositif de commande à distance échange avec l'appareil audio au moins un signal de commande sur lequel est codée la commande. Selon l'invention, ledit au moins un signal de commande (18) est généré dans une bande de fréquence non-audio et superposé audit au moins un signal audio, sur ledit médium. L'invention concerne également le dispositif de commande à distance (1), qui comprend des moyens (10) de codage de la commande sur ledit au moins un signal de commande, et l'appareil audio (2), qui comprend des moyens (13) de décodage de la commande codée sur ledit au moins un signal de commande.

## Description

L'invention concerne la transmission d'une commande d'un dispositif de commande à distance vers un appareil audio muni d'au moins un accessoire audio. L'invention concerne également le dispositif de commande à distance et l'appareil audio permettant la mise en oeuvre d'une telle transmission.

La présente invention s'applique notamment, mais non exclusivement, à la commande à distance d'un terminal mobile de radiocommunication ou d'un baladeur (radio et/ou cassette et/ou compact disc), dont l'accessoire audio est un casque comprenant au moins un écouteur et/ou au moins un microphone.

On rappelle que l'intérêt d'un tel dispositif de commande à distance est de permettre à un utilisateur de commander un appareil audio non aisément accessible (par exemple parce qu'il se trouve dans un sac ou dans une poche).

D'une façon générale, on distingue les deux types d'échange de signaux suivants : l'échange d'un ou plusieurs signaux audio entre l'appareil audio et l'accessoire audio ; et l'échange d'un ou plusieurs signaux de commande entre le dispositif de commande à distance et l'appareil audio.

Classiquement, dans l'appareil audio, chaque commande contenue dans (c'est-à-dire codée sur) un signal de commande, après la réception et le traitement de ce dernier, est fournie à un processeur qui gère l'exécution de ces commandes.

Chaque commande traduit un choix effectué par l'utilisateur (par exemple grâce à une ou plusieurs touches dont est muni le dispositif de commande à distance) en vue de modifier le fonctionnement de l'appareil audio. Il s'agit par exemple d'une commande permettant de régler le volume sonore (augmentation/baisse), de passer d'une plage de lecture à une autre (avance/recul), de naviguer dans un menu déroulant (haut/bas), d'arrêter ou de marquer une pause lors de la lecture (stop/pause), de "décrocher" un appel entrant (ou prendre la communication) quand le téléphone sonne, de "raccrocher" (ou mettre fin à la communication), etc. Il est clair que cette liste n'est en aucune façon exhaustive.

Traditionnellement, l'échange du ou des signaux audio, entre l'appareil audio et l'accessoire audio, est effectué sur un premier médium.

Par exemple, dans le cas d'un baladeur (cassette et/ou autre) muni d'un casque, le premier médium reliant ces deux éléments entre eux comprend un fil de masse et un ou plusieurs fils d'audio. Généralement, les fils de masse et d'audio sont regroupés dans un même câble. Ainsi, un casque stéréo est généralement relié au baladeur par un câble comprenant, outre le fil de masse, deux fils d'audio destinés respectivement aux écouteurs "droite et gauche" du casque. De même, dans le cas d'un téléphone sans fil, le casque avec microphone, de type monophonique, est relié au téléphone sans fil par un câble comprenant, outre le fil de masse, deux fils d'audio destinés respectivement aux écouteurs et au microphone du casque, les deux écouteurs étant reliés au même fil d'audio.

Egalement de façon traditionnelle, l'échange du ou des signaux de commande, du dispositif de commande à distance vers l'appareil audio, est effectué sur un second médium, distinct du premier médium.

Ainsi, dans le cas précité d'un baladeur cassette muni d'un casque, le dispositif de commande à distance est généralement relié à l'appareil audio par un second médium comprenant un ou plusieurs fils de commande, distincts du fil de masse et du ou des fils d'audio. Chaque fil de commande permet par exemple la transmission d'un ou de plusieurs types de commande particuliers.

Dans la pratique, pour des raisons de facilité d'utilisation, le ou les fils de commande (constituant le second médium) sont généralement placés dans le même câble que le fil de masse et le ou les fils d'audio (constituant le premier médium). En outre, le dispositif de commande à distance est généralement placé entre l'appareil audio et l'accessoire audio.

En d'autres termes, un unique câble comprend généralement deux tronçons successifs, à savoir :
- un premier tronçon, compris entre l'appareil audio et le dispositif de commande à distance, et comprenant le fil de masse, le ou les fils d'audio et le ou les fils de commande ;
- un second tronçon, compris entre le dispositif de commande à distance et l'accessoire audio, et comprenant uniquement le fil de masse et le ou les fils d'audio.

En outre, le câble est généralement relié à l'appareil audio par l'intermédiaire d'un ou plusieurs premiers connecteurs présentant au total M connexions (ou broches de connexion), avec : M = X + Y + 1, où X est le nombre de fil d'audio, Y est le nombre de fil de commande et 1 correspond au fil de masse. Chaque premier connecteur (mâle ou femelle) est destiné à coopérer avec un second connecteur (femelle ou mâle) présent sur une des faces de l'appareil audio.

Plus précisément, on utilise classiquement les éléments de connexion suivants (d'une part à l'extrémité du câble et d'autre part, de façon symétrique, à la surface de l'appareil audio) :
- soit une combinaison d'une fiche jack standard (ou "standard jack plug" en anglais) à X + 1 connexions (qui est donc utilisée uniquement pour le ou les fils d'audio et le fil de masse) et d'un connecteur annexe non-standard à Y connexions (qui est donc utilisé uniquement pour le ou les fils de commande) ;
- soit un unique connecteur non-standard à M connexions (incluant éventuellement une fiche jack standard à X + 1 connexions).

Il apparaît malheureusement que la solution actuelle précitée, basée sur l'utilisation d'un premier et d'un second média distincts, présente plusieurs inconvénients.

Tout d'abord, la réalisation de deux média distincts nécessite l'utilisation d'un nombre relativement élevé de ressources et de matériels. Ainsi, dans l'exemple précité, le câble regroupant les premier et second média comprend un nombre important de fils (à savoir M = X + Y + 1).

De plus, comme expliqué ci-dessus, ce nombre important de fils empêche l'utilisation, à l'extrémité du câble comme à la surface de l'appareil audio, d'une unique fiche jack standard (c'est-à-dire prévue uniquement pour le fil de masse et le ou les X fils d'audio). En d'autres termes, cela implique l'utilisation soit d'un connecteur annexe non-standard (pour le ou les fils de commande) en combinaison avec la fiche jack standard, soit d'un unique connecteur non-standard à M connexions (pour l'ensemble des fils).

Dans les deux cas, la partie non-standard de la connexion (connecteur annexe ou unique connecteur tout entier) induit une augmentation du coût de fabrication de l'ensemble du connecteur.

En outre, le nombre de broches de connexion étant élevé, la fragilité de la connexion, ainsi que la surface réservée au connecteur associé sur l'appareil audio, s'en trouvent toutes les deux augmentées.

L'invention a notamment pour objectif de pallier ces différents inconvénients de l'état de la technique.

Plus précisément, l'un des objectifs de la présente invention est de permettre la transmission d'une commande d'un dispositif de commande à distance vers un appareil audio, en réduisant les quantité de ressource et de matériel (par exemple le nombre de fil) nécessaires.

L'invention a également pour objectif, dans le cas où le premier médium comprend un fil de masse et X fil(s) d'audio regroupés dans un câble, de permettre l'utilisation, à l'extrémité du câble comme à la surface de l'appareil audio, d'une unique fiche jack standard (c'est-à-dire prévue uniquement pour le fil de masse et le(s) X fil(s) d'audio).

Ces différents objectifs, ainsi que d'autres qui apparaîtront par la suite, sont atteints selon l'invention à l'aide d'un procédé de transmission d'une commande d'un dispositif de commande à distance vers un appareil audio, ledit appareil audio échangeant, sur un médium, au moins un signal audio avec un accessoire audio. ledit dispositif de commande à distance échangeant avec ledit appareil audio au moins un signal de commande sur lequel est codée ladite commande,
caractérisé en ce qu'il comprend les étapes suivantes :
- génération dudit au moins un signal de commande dans une bande de fréquence non-audio, distincte d'une bande de fréquence audio dans laquelle est situé ledit au moins un signal audio ;
- superposition dudit au moins un signal de commande et dudit au moins un signal audio sur ledit médium.

Le principe général de l'invention consiste donc à multiplexer en fréquence, sur un unique médium, le ou les signaux audio et le ou les signaux de commande. Pour permettre un tel multiplexage en fréquence, l'invention impose donc que le ou les signaux de commande soient situés dans une bande de fréquence distincte de la bande audio.

Ainsi, contrairement à la solution de l'art antérieur (discutée ci-dessus), la présente invention ne nécessite pas de second médium entre l'appareil audio et le dispositif de commande à distance. On rappelle en effet que dans l'art antérieur, le ou les signaux audio sont transmis sur un premier médium, tandis que le ou les signaux de commande sont transmis sur un second médium.

L'invention concerne également un dispositif de commande à distance d'un appareil audio, ledit appareil audio échangeant, sur un médium, au moins un signal audio avec un accessoire audio, ledit dispositif de commande à distance échangeant avec ledit appareil audio au moins un signal de commande sur lequel est codée ladite commande,
caractérisé en ce que ledit au moins un signal de commande est d'une part dans une bande de fréquence non-audio, distincte d'une bande de fréquence audio dans laquelle est situé ledit au moins un signal audio, et d'autre part superposé audit au moins un signal audio, sur ledit médium,
et en ce que ledit dispositif de commande à distance comprend des moyens de codage de ladite commande sur ledit au moins un signal de commande.

Il est clair que les moyens de codage peuvent permettre le codage d'une pluralité de commandes distinctes, offrant ainsi à l'utilisateur de nombreuses possibilités pour modifier le fonctionnement de l'appareil audio (par exemple, le réglage du volume sonore, le passage d'une plage de lecture à une autre, la navigation dans un menu déroulant, l'arrêt ou la pause lors de la lecture, le décrochage d'un appel entrant, le raccrochage de fin de communication, ...).

Dans un premier mode de réalisation particulier de l'invention, ledit dispositif de commande à distance comprend des moyens de génération dudit au moins un signal de commande dans ladite bande de fréquence non-audio, et des moyens de superposition dudit au moins un signal de commande audit au moins un signal audio, sur ledit médium.

En d'autres termes, dans ce premier mode de réalisation, le dispositif de commande à distance effectue non seulement le codage de la commande, mais également la génération et la superposition du signal de commande sur lequel est codée la commande. Comme expliqué par la suite, dans un second mode de réalisation, la génération et la superposition du signal de commande sont effectuées par l'appareil audio.

Lorsque ledit médium comprend, entre ledit appareil audio et ledit dispositif de commande, un ensemble de fil comprenant un fil de masse et au moins un fil d'audio, alors, avantageusement, l'unique fil d'audio ou au moins un des fils d'audio, dit fil d'audio/commande, est également utilisé comme fil de commande.

En d'autres termes, le dispositif de commande à distance de la présente invention ne nécessite aucun fil supplémentaire. En effet, un ou plusieurs fils d'audio sont doublement utilisés, à savoir une première fois pour l'audio et une seconde fois pour la commande à distance.

Dans un mode de réalisation avantageux de l'invention, ledit ensemble de fil est relié audit appareil audio par l'intermédiaire d'une première fiche jack à N connexions, avec N = X + 1, où X est le nombre de fil d'audio et 1 correspond au fil de masse, au moins un fil d'audio/commande étant compris dans ledit nombre X de fil d'audio, ladite première fiche jack étant destinée à coopérer avec une seconde fiche jack comprise dans ledit appareil audio.

Il est important de noter que la présente invention peut être mise en oeuvre avec des fiches jack standards (c'est-à-dire initialement conçues uniquement pour l'audio), qui présentent l'avantage d'être meilleur marché et moins fragiles.

Préférentiellement, ledit dispositif de commande à distance comprend des moyens de blocage dudit au moins un signal de commande, de façon que ledit accessoire audio ne reçoive pas ledit au moins un signal de commande.

En d'autres termes, l'accessoire audio reçoit uniquement ledit au moins un signal audio, seul l'appareil audio recevant ledit au moins un signal de commande. Ceci permet d'améliorer le traitement dudit signal audio par l'accessoire audio, en supprimant (ou à tout le moins en réduisant) le bruit éventuel dû audit au moins un signal de commande.

Dans un premier mode de réalisation préférentiel de l'invention, ledit au moins un signal de commande est un signal à courant continu dont la fréquence nulle est comprise dans ladite bande de fréquence non-audio,
et lesdits moyens de codage de ladite commande comprennent des moyens de modification et/ou de modulation d'au moins une caractéristique dudit signal à courant haute fréquence, de façon que chaque commande et/ou combinaison de commandes simultanées corresponde à un ensemble particulier de caractéristiques dudit signal à courant haute fréquence.

Dans un second mode de réalisation préférentiel de l'invention, ledit au moins un signal de commande est un signal à courant haute fréquence dont la (les) fréquence(s) est (sont) comprise(s) dans ladite bande de fréquence non-audio,
et lesdits moyens de codage de ladite commande comprennent des moyens de modification de la fréquence ou des fréquences dudit signal à courant haute fréquence, de façon que chaque commande corresponde à une haute fréquence prédéterminée distincte ou à une combinaison prédéterminée distincte d'au moins deux hautes fréquences.

L'invention concerne également un appareil audio, du typc destiné à être commandé à distance par un dispositif de commande à distance, ledit appareil audio échangeant, sur un médium, au moins un signal audio avec un accessoire audio, ledit dispositif de commande à distance échangeant avec ledit appareil audio au moins un signal de commande sur lequel est codée ladite commande,
caractérisé en ce que ledit au moins un signal de commande est d'une part dans une bande de fréquence non-audio, distincte d'une bande de fréquence audio dans laquelle est situé ledit au moins un signal audio, et d'autre part superposé audit au moins un signal audio, sur ledit médium,
et en ce que ledit appareil audio comprend des moyens de décodage de ladite commande codée sur ledit au moins un signal de commande.

On rappelle que l'avantage principal de la présente invention est de ne nécessiter qu'un unique médium, entre l'appareil audio et le dispositif de commande à distance, pour la transmission tant du ou des signaux audio que du ou des signaux de commande. Ceci permet notamment l'utilisation de fiches jack standards, plus solides et moins coûteuses que les connecteurs non-standards.

Dans un second mode de réalisation particulier de l'invention, ledit appareil audio comprend des moyens de génération dudit au moins un signal de commande dans ladite bande de fréquence non-audio, et des moyens de superposition dudit au moins un signal de commande audit au moins un signal audio, sur ledit médium.

On rappelle que dans le premier mode de réalisation précité, c'est le dispositif de commande à distance qui effectue non seulement le codage de la commande, mais également la génération et la superposition du signal de commande sur lequel est codée la commande.

De façon avantageuse, ledit appareil audio comprend des moyens de détection préalable de la présence de ladite commande codée sur ledit au moins un signal de commande.

De cette façon, on peut n'activer les autres moyens (notamment les moyens de décodage) que lorsqu'un commande est effectivement transmise par le dispositif de commande à distance. Ainsi, ces autres moyens peuvent être mis "en sommeil" le reste du temps, de façon à réduire la consommation d'énergie de l'appareil audio. Ceci est très important si l'appareil audio possède une autonomie limitée, ce qui est typiquement le cas de la plupart des balladeurs ou des terminaux mobiles.

De façon préférentielle, ledit appareil audio appartient au groupe comprenant les terminaux mobiles de radiocommunication et les baladeurs radio et/ou cassette et/ou compact disc.

Avantageusement, ledit accessoire audio est un casque comprenant au moins un écouteur et/ou au moins un microphone.

Dans un premier mode de réalisation préférentiel de l'invention, ledit au moins un signal de commande est un signal à courant continu dont la fréquence nulle est comprise dans ladite bande de fréquence non-audio,
et lesdits moyens de décodage de ladite commande comprennent des moyens de détection de l'intensité dudit signal à courant continu, chaque commande distincte correspondant à une intensité prédéterminée distincte dudit signal à courant continu.

Dans un second mode de réalisation préférentiel de l'invention, ledit au moins un signal de commande est un signal à courant haute fréquence dont la (les) fréquence(s) est (sont) comprise(s) dans ladite bande de fréquence non-audio,
et lesdits moyens de décodage de ladite commande comprennent des moyens de détection des caractéristiques du signal à courant haute fréquence, chaque commande et/ou combinaison de commandes simultanées correspondant à un ensemble particulier de caractéristiques du signal à courant haute fréquence.

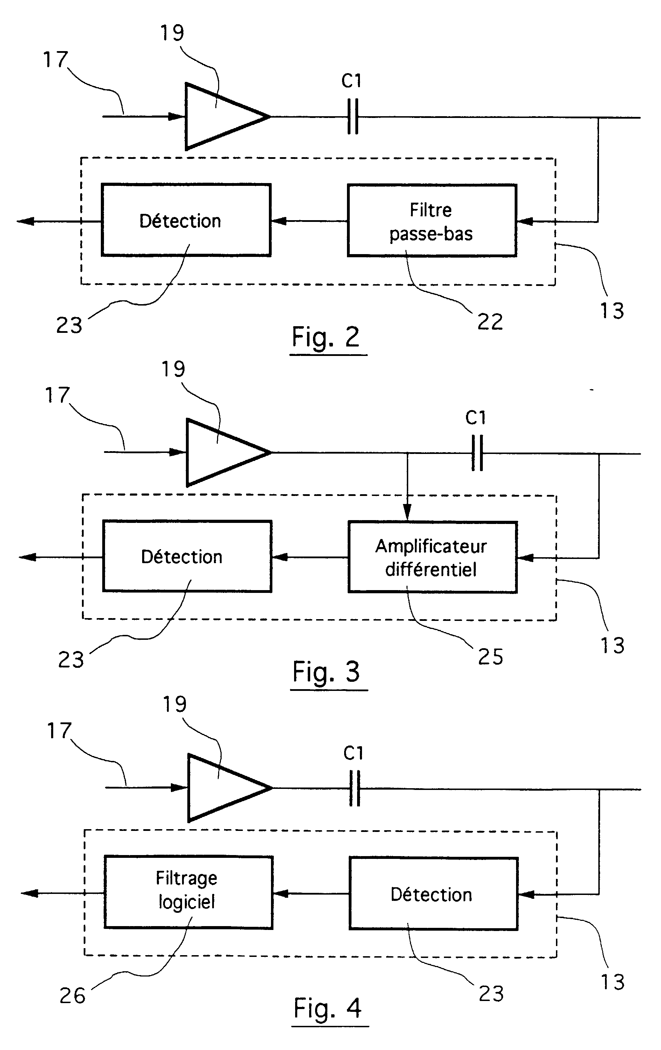

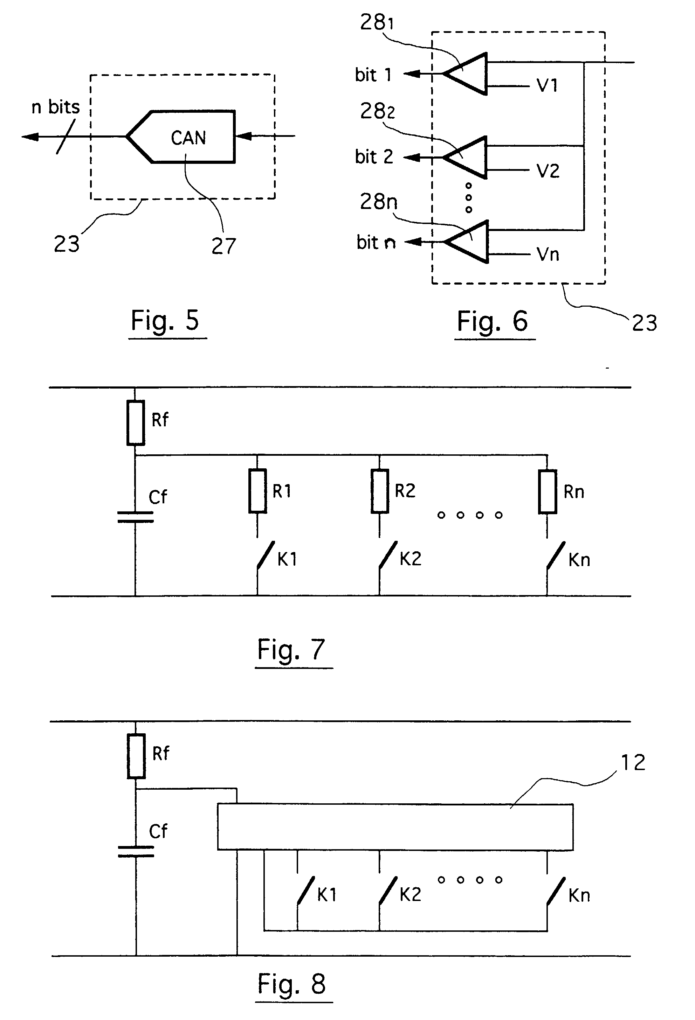

D'autres caractéristiques et avantages de l'invention apparaîtront à la lecture de la description suivante d'un mode de réalisation préférentiel de l'invention, donné à titre d'exemple indicatif et non limitatif, et des dessins annexés, dans lesquels :

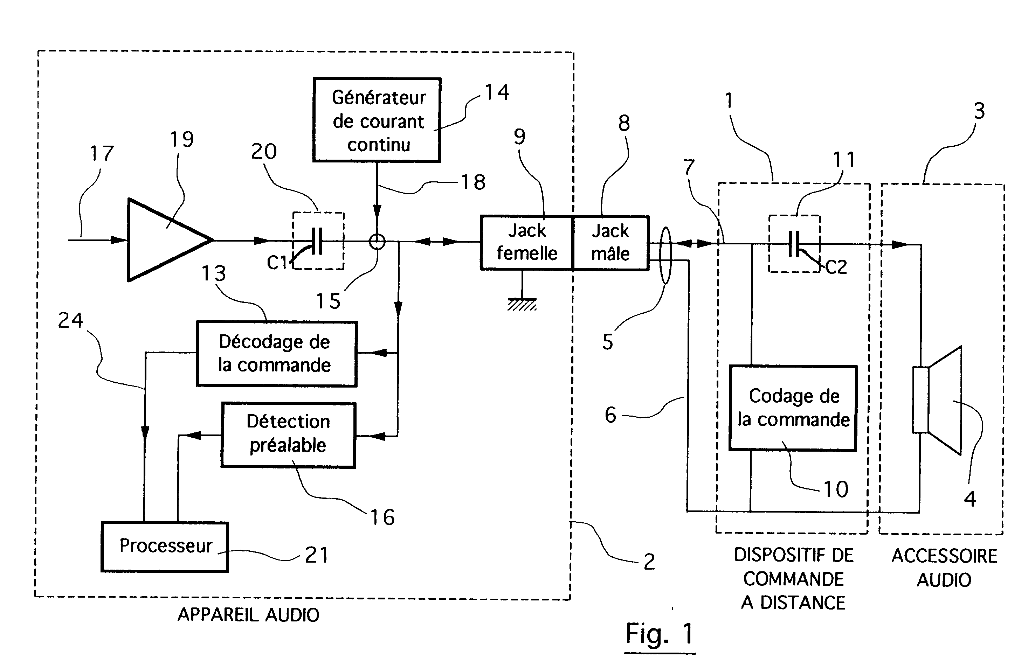

- la figure 1 présente un synoptique simplifié d'un mode de réalisation particulier d'un dispositif de commande à distance et d'un appareil audio avec son accessoire audio, selon la présente invention ;
- chacune des figures 2 à 4 présente un mode de réalisation particulier distinct des moyens de décodage de commande compris dans l'appareil audio de la figure 1 ;
- chacune des figures 5 et 6 présente un mode de réalisation particulier distinct des moyens de détection compris dans les moyens de décodage de commande de chacune des figures 2 à 4 ; et
- chacune des figures 7 et 8 présente un mode de réalisation particulier distinct des moyens de codage de commande compris dans le dispositif de commande à distance de la figure 1.

Comme présenté sur le synoptique de la figure 1, on s'intéresse donc ici à la commande à distance, par un dispositif de commande à distance 1, d'un appareil audio 2 muni d'un accessoire audio 3.

Il est clair qu'il existe de nombreux types d'appareils audio, tels que notamment, mais non exclusivement, les baladeurs (radio et/ou cassette et/ou compact disc) et les terminaux mobiles de radiocommunication. D'une façon générale, on entend ici par appareil audio tout appareil traitant notamment :
- au moins un signal audio de sortie, lu sur un support de stockage (tel qu'une cassette, un compact disc, une mémoire, ...) ou reçu de l'extérieur (par exemple par voie hertzienne pour la radio et la radiocommunication), et destiné à être converti en ondes sonores par un haut-parleur (ou écouteur) ; et/ou
- au moins un signal audio d'entrée, provenant de la conversion d'ondes sonores par un microphone, et destiné à être stocké sur un support de stockage et/ou transmis vers l'extérieur.

Dans le cadre de la présente invention, on suppose que l'appareil audio 2 est du type pouvant coopérer avec un accessoire audio 3, de façon à déporter vers l'accessoire audio 3, si nécessaire, la conversion signal(ux) audio/ondes sonores et/ou la conversion ondes sonores/signal(ux) audio. D'une façon générale, un accessoire audio comprend notamment au moins un écouteur (ou haut-parleur) et/ou au moins un microphone. Il est clair que l'appareil audio 2 peut comprendre lui aussi de tels moyens de transduction, à savoir écouteur(s) et/ou microphone(s).

Classiquement, l'appareil audio 2 et l'accessoire audio 3 échangent le ou les signaux audio sur un médium d'échange 5. Le médium d'échange 5 comprend par exemple un ensemble de fils, regroupé dans un câble et comprenant un fil de masse et un ou plusieurs fil(s) d'audio. L'extrémité libre du câble 5 est reliée à une première fiche jack 8 destinée à coopérer avec une seconde fiche jack 9 comprise dans l'appareil audio 2. L'une des deux prises jack est du type femelle (par exemple la seconde 9) et l'autre du type mâle (par exemple la première 8).

Dans le mode de réalisation particulier présenté ci-dessous, l'accessoire audio 3 est un casque comprenant, dans un souci de simplication, un seul moyen de transduction, à savoir un écouteur 4. Dans ce cas, le médium d'échange 5 ne comprend que deux fils, à savoir un fil de masse 6 et un fil d'audio 7. On suppose donc par la suite que l'appareil audio 2 traite un seul signal audio de sortie 17, destiné à être converti en ondes sonores par l'écouteur 4 de l'accessoire audio 3.

Il est clair cependant que la présente invention s'applique quel que soit le nombre de fils d'audio, l'homme du métier pouvant aisément généraliser à n'importe quel autre cas les explications données ici.

Classiquement, le dispositif de commande à distance 1 émet un ou plusieurs signaux de commande vers l'appareil audio 2, de façon à en commander le fonctionnement. On rappelle que le dispositif de commande à distance 1 doit être aisément accessible à l'utilisateur, de façon à lui permettre de commander l'appareil audio 2, qui lui en revanche n'est pas aisément accessible (par exemple parce qu'il se trouve dans un sac ou dans une poche).

Selon la présente invention, pour l'échange des signaux de commande entre le dispositif de commande à distance 1 et l'appareil audio 2, on utilise à nouveau le médium d'échange 5 existant (qui permet déjà l'échange du ou des signaux audio 17 entre l'appareil audio 2 et l'accessoire audio 3).

Pour cela, l'invention propose un procédé de transmission d'une commande, du dispositif de commande à distance 1 vers l'appareil audio 2, comprenant les étapes suivantes : génération du ou des signaux de commande 18 dans une bande de fréquence non-audio, distincte d'une bande de fréquence audio dans laquelle est situé le signal audio 17 ; et superposition du ou des signaux de commande 18 et du signal audio 17, sur le médium d'échange 5.

En d'autres termes, le ou les signaux de commande 18 sont d'une part dans une bande de fréquence non-audio et d'autre part superposé au signal audio 17, sur le médium d'échange 5.

Dans un souci de simplification, on considère dans la suite de la description que le dispositif de commande à distance 1 et l'appareil audio 2 échangent un seul signal de commande 18.

Ainsi, en reprenant l'exemple déjà discuté ci-dessus, ceci signifie que cet unique signal de commande 18 est lui aussi échangé grâce aux deux fils 6, 7 du médium d'échange 5, à savoir à savoir le fil de masse 6 et le fil d'audio 7. Afin de rappeler sa double fonction, le fil d'audio 7 peut être appelé "fil d'audio/commande".

Il est clair cependant que la présente invention s'applique quel que soit le nombre de signaux de commande. En effet, il est tout à fait possible de superposer, par exemple sur un couple (fil de masse, fil d'audio/commande), plusieurs signaux de commande avec un même signal audio. En outre, si l'on dispose de plusieurs signaux audio, chacun peut être superposé avec un ou plusieurs signaux de commande. Dans ce second cas, on a alors plusieurs couples (fil de masse, fil d'audio/commande).

On présente maintenant plus en détail un mode de réalisation particulier du dispositif de commande à distance 1 et de l'appareil audio 2.

Par hypothèse, le signal audio 17 est un signal à courant alternatif, dont la ou les fréquences sont comprises dans la bande de fréquence audio.

Dans ce mode de réalisation particulier, on prend comme signal de commande 18 un signal à courant continu (dont la fréquence nulle est donc bien en dehors de la bande audio).

Le dispositif de commande à distance 1 comprend des moyens 10 de codage d'une commande (parmi une pluralité) sur le signal à courant continu 18 (c'est-à-dire sur le signal de commande). Ces moyens 10 de codage comprennent eux-mêmes des moyens de modification de l'intensité du signal à courant continu 18, en fonction par exemple de la touche sur laquelle a appuyé l'utilisateur. Chaque commande distincte correspond à une intensité prédéterminée distincte du signal à courant continu.

Chacune des figures 7 et 8 présente un mode de réalisation particulier distinct de ces moyens 10 de codage de commande. Dans les deux modes de réalisation, un filtre passe-bas (Rf - Cf) permet de lisser les variations de la tension à courant continu, afin d'éviter l'apparition d'un signal dans la bande audio et donc d'un bruit sonore dans l'écouteur lorsqu'une touche est enfoncée.

Dans le premier mode de réalisation des moyens 10 de codage (fig.7), chaque touche (ou commutateur) K1 à Kn est associée à une résistance R1 à Rn ayant une valeur distincte. A chaque fois que l'utilisateur appuie sur une touche, la résistance correspondante modifie l'intensité du signal à courant continu 18 (c'est-à-dire la valeur de la tension à courant continu), après un temps d'établissement dû au filtre Rf - Cf.

Dans le second mode de réalisation des moyens 10 de codage (fig.8), la variation de l'intensité du signal à courant continu 18, lorsqu'une touche (ou commutateur) K1 à Kn est enfoncée par l'utilisateur, est établie par un générateur (de courant ou de tension) programmable 12.

Encore un autre mode de réalisation des moyens 10 de codage, non illustré, consiste à utiliser un réseau résistif complexe connecté aux touches.

Optionnellement, le dispositif de commande à distance 1 comprend également des premiers moyens 11 de blocage du signal de commande 18 (par exemple sous la forme d'un condensateur C2), de façon que l'accessoire audio 3 ne le reçoive pas. Il est clair que ces moyens 11 de blocage du signal de commande 18 sont facultatifs, l'accessoire audio 3 pouvant être intrinsèquement insensible au signal de commande 18.

L'appareil audio 2 comprend des moyens 13 de décodage de la commande codée sur le signal de commande 18. Ces moyens 13 de décodage comprennent eux-mêmes des moyens de détection de l'intensité du signal à courant continu. On rappelle que dans ce mode de réalisation, après codage par les moyens 10 de codage compris dans le dispositif de commande à distance 1, chaque commande distincte correspond à une intensité prédéterminée distincte du signal à courant continu 18. Après décodage, la commande 24 est envoyée à un moyen de traitement 21 (par exemple un processeur) qui gère l'exécution de l'action correspondant à cette commande.

L'appareil audio 2 comprend en outre :
- un amplificateur audio 19, permettant d'amplifier le signal audio 17 ;
- des seconds moyens 20 de blocage du signal de commande 18 (par exemple sous la forme d'un condensateur C1), de façon que l'amplificateur audio 19 ne puisse pas perturber ou être perturbé par le signal de commande 18 ou la bande de fréquence non-audio correspondante ;
- des moyens 14 de génération du signal de commande 18, dans la bande de fréquence non-audio. Il peut s'agir d'une simple résistance connectée à une alimentation en courant continu, ou bien un générateur de courant ;
- des moyens 15 de superposition du signal de commande 18 au signal audio 17, sur le médium d'échange 5.

Chacune des figures 2, 3 et 4 présente un mode de réalisation particulier distinct des moyens 13 de décodage.

Dans le premier mode de réalisation (fig.2), les moyens 13 de décodage comprennent :
- un filtre passe-bas 22, de façon à laisser passer le signal à courant continu 18 (c'est-à-dire le signal de commande), et supprimer le signal à courant alternatif 17 (c'est-à-dire le signal audio). Il s'agit par exemple d'un simple réseau R-C ;
- des moyens 23 de détection de l'intensité du signal à courant continu 18 (cf ci-dessous la description détaillées de deux modes de réalisation). Ces moyens 23 de détection permettent de déterminer la touche enfoncée par l'utilisateur (c'est-à-dire la commande codée par les moyens 10 de codage du dispositif de commande à distance 1). On rappelle en effet que chaque commande distincte correspond à une intensité prédéterminée distincte du signal à courant continu 18.

Le second mode de réalisation (fig.3) des moyens 13 de décodage diffère du premier mode de réalisation (fig.2) en ce que le filtre passe-bas 22 est remplacé par un amplificateur différentiel 25.

Le troisième mode de réalisation (fig.4) des moyens 13 de décodage diffère du premier mode de réalisation (fig.2) en ce que le filtre passe-bas 22 est remplacé par des moyens 26 de filtrage logiciel, placés en aval des moyens 23 de détection et permettant de corriger les effets du signal à courant alternatif 17 sur les moyens 23 de détection.

Chacune des figures 5 et 6 présente un mode de réalisation particulier distinct des moyens 23 de détection compris dans les moyens 13 de décodage.

Dans le premier mode de réalisation (fig.5), les moyens 23 de détection de l'intensité du signal à courant continu 18 comprennent un convertisseur analogique/numérique 27, assurant la conversion du signal à courant continu 18 sous une forme numérique (par exemple sur n bits) utilisable par le processeur 21.

Le second mode de réalisation (fig.6) des moyens 23 de détection diffère du premier mode de réalisation (fig.5) en ce que le convertisseur analogique/numérique 27 est remplacé par un ensemble de comparateurs 28₁ à 28ₙ, permettant la comparaison du signal à courant continu 18 avec un ensemble de valeurs seuil V1 à Vn de tension à courant continu.

Optionnellement, l'appareil audio 2 comprend en outre des moyens 16 de détection préalable de la présence d'une commande codée sur le signal de commande 18. Ces moyens 16 peuvent être construits autour d'un simple comparateur.

Il est clair que de nombreux autres modes de réalisation de l'invention peuvent être envisagés.

Notamment, le signal de commande 18 n'est pas obligatoirement un signal à courant continu. Ainsi, selon une variante de l'invention, on prend comme signal de commande 18 un signal à courant haute fréquence, dont la (les) fréquence(s) est (sont) comprise(s) dans une ou plusieurs bande(s) de fréquence non-audio. En d'autres termes, elle(s) n'est (ne sont) pas comprise(s) dans la bande de fréquence audio.

Dans le cas d'une telle variante, les moyens de codage de la commande comprennent des moyens de modification et/ou de modulation d'une ou de plusieurs caractéristiques du signal à courant haute fréquence (c'est-à-dire du signal de commande), cette modification et/ou modulation pouvant porter sur la fréquence et/ou l'amplitude et/ou la phase du signal haute fréquence, ou être une modulation plus complexe, de façon que chaque commande et/ou combinaison de commandes simultanées corresponde à un ensemble particulier de caractéristiques du signal à courant haute fréquence. Par ailleurs, les moyens de décodage de la commande comprennent des moyen de détection des caractéristiques du signal à courant haute fréquence, chaque commande et/ou combinaison de commandes simultanées correspondant à un ensemble particulier de caractéristiques du signal à courant haute fréquence.

On peut également envisager, sans sortir du cadre de l'invention, de placer dans le dispositif de commande à distance 1 (et non plus dans l'appareil audio 2) les moyens 14 de génération du signal de commande 18 et les moyens 15 de superposition du signal de commande 18 au signal audio 17, sur le médium d'échange 5.

## Revendications

1. Procédé de transmission d'une commande d'un dispositif de commande à distance (1) vers un appareil audio (2), ledit appareil audio échangeant, sur un médium (5), au moins un signal audio (17) avec un accessoire audio (3), ledit dispositif de commande à distance échangeant avec ledit appareil audio au moins un signal de commande sur lequel est codée ladite commande,
caractérisé en ce qu'il comprend les étapes suivantes :
- génération dudit au moins un signal de commande (18) dans une bande de fréquence non-audio, distincte d'une bande de fréquence audio dans laquelle est situé ledit au moins un signal audio ;
- superposition dudit au moins un signal de commande et dudit au moins un signal audio sur ledit médium.

2. Dispositif de commande à distance (1) d'un appareil audio (2), ledit appareil audio échangeant, sur un médium (5), au moins un signal audio (17) avec un accessoire audio (3), ledit dispositif de commande à distance échangeant avec ledit appareil audio au moins un signal de commande sur lequel est codée ladite commande,
caractérisé en ce que ledit au moins un signal de commande (18) est d'une part dans une bande de fréquence non-audio, distincte d'une bande de fréquence audio dans laquelle est situé ledit au moins un signal audio, et d'autre part superposé audit au moins un signal audio, sur ledit médium,
et en ce que ledit dispositif de commande à distance comprend des moyens (10) de codage de ladite commande sur ledit au moins un signal de commande.

3. Dispositif de commande à distance selon la revendication 2, caractérisé en ce qu'il comprend :
- des moyens de génération dudit au moins un signal de commande dans ladite bande de fréquence non-audio ;
- des moyens de superposition dudit au moins un signal de commande audit au moins un signal audio, sur ledit médium.

4. Dispositif de commande à distance selon l'une quelconque des revendications 2 et 3, ledit médium comprenant, entre ledit appareil audio et ledit dispositif de commande, un ensemble de fils comprenant un fil de masse (6) et au moins un fil d'audio (7),
caractérisé en ce que l'unique fil d'audio (7) ou au moins un des fils d'audio, dit fil d'audio/commande, est également utilisé comme fil de commande.

5. Dispositif de commande à distance selon la revendication 4, caractérisé en ce que ledit ensemble de fil est relié audit appareil audio par l'intermédiaire d'une première fiche jack (8) à N connexions, avec N = X + 1, où X est le nombre de fil d'audio (7) et 1 correspond au fil de masse (6), au moins un fil d'audio/commande (7) étant compris dans ledit nombre X de fil d'audio, ladite première fiche jack étant destinée à coopérer avec une seconde fiche jack (9) comprise dans ledit appareil audio.

6. Dispositif de commande à distance selon l'une quelconque des revendications 2 à 5, caractérisé en ce qu'il comprend des moyens (11) de blocage dudit au moins un signal de commande (18), de façon que ledit accessoire audio (3) ne reçoive pas ledit au moins un signal de commande.

7. Dispositif de commande à distance selon l'une quelconque des revendications 2 à 6, ledit au moins un signal audio étant un signal à courant alternatif (17) dont la (les) fréquence(s) est (sont) comprise(s) dans ladite bande de fréquence audio,
caractérisé en ce que ledit au moins un signal de commande est un signal à courant continu (18) dont la fréquence nulle est comprise dans ladite bande de fréquence non-audio,
et en ce que lesdits moyens (10) de codage de ladite commande comprennent des moyens de modification de l'intensité dudit signal à courant continu, de façon que chaque commande distincte corresponde à une intensité prédéterminée distincte dudit signal à courant continu.

8. Dispositif de commande à distance selon l'une quelconque des revendications 2 à 6, ledit au moins un signal audio étant un signal à courant alternatif dont la (les) fréquence(s) est (sont) comprise(s) dans ladite bande de fréquence audio,
caractérisé en ce que ledit au moins un signal de commande est un signal à courant haute fréquence dont la (les) fréquence(s) est (sont) comprise(s) dans ladite bande de fréquence non-audio,
et en ce que lesdits moyens de codage de ladite commande comprennent des moyens de modification et/ou de modulation d'au moins une caractéristique dudit signal à courant haute fréquence, de façon que chaque commande et/ou combinaison de commandes simultanées corresponde à un ensemble particulier de caractéristiques dudit signal à courant haute fréquence.

9. Appareil audio (2), du type destiné à être commandé à distance par un dispositif de commande à distance (1), ledit appareil audio échangeant, sur un médium (5), au moins un signal audio (17) avec un accessoire audio (3), ledit dispositif de commande à distance échangeant avec ledit appareil audio au moins un signal de commande sur lequel est codée ladite commande,
caractérisé en ce que ledit au moins un signal de commande (18) est d'une part dans une bande de fréquence non-audio, distincte d'une bande de fréquence audio dans laquelle est situé ledit au moins un signal audio, et d'autre part superposé audit au moins un signal audio, sur ledit médium,
et en ce que ledit appareil audio comprend des moyens (13) de décodage de ladite commande codée sur ledit au moins un signal de commande.

10. Appareil audio selon la revendication 9, caractérisé en ce qu'il comprend :
- des moyens (14) de génération dudit au moins un signal de commande (18) dans ladite bande de fréquence non-audio ;
- des moyens (15) de superposition dudit au moins un signal de commande (18) audit au moins un signal audio (17), sur ledit médium (5).

11. Appareil audio selon l'une quelconque des revendications 9 et 10. caractérisé en ce qu'il comprend des moyens (16) de détection préalable de la présence de ladite commande codée sur ledit au moins un signal de commande.

12. Appareil audio selon l'une quelconque des revendications 9 à 11, caractérisé en ce qu'il appartient au groupe comprenant :
- les terminaux mobiles de radiocommunication ;
- les baladeurs radio et/ou cassette et/ou compact disc.

13. Appareil audio selon l'une quelconque des revendications 9 à 12, caractérisé en ce que ledit accessoire audio (3) est un casque comprenant au moins un écouteur (4) et/ou au moins un microphone.

14. Appareil audio selon l'une quelconque des revendications 9 à 13, ledit au moins un signal audio étant un signal à courant alternatif (17) dont la (les) fréquence(s) est (sont) comprise(s) dans ladite bande de fréquence audio,
caractérisé en ce que ledit au moins un signal de commande est un signal à courant continu (18) dont la fréquence nulle est comprise dans ladite bande de fréquence non-audio,
et en ce que lesdits moyens (13) de décodage de ladite commande comprennent des moyens de détection de l'intensité dudit signal à courant continu, chaque commande distincte correspondant à une intensité prédéterminée distincte dudit signal à courant continu.

15. Appareil audio selon l'une quelconque des revendications 9 à 13, ledit au moins un signal audio étant un signal à courant alternatif dont la (les) fréquence(s) est (sont) comprise(s) dans ladite bande de fréquence audio,
caractérisé en ce que ledit au moins un signal de commande est un signal à courant haute fréquence dont la (les) fréquence(s) est (sont) comprise(s) dans ladite bande de fréquence non-audio,
et en ce que lesdits moyens de décodage de ladite commande comprennent des moyens de détection des caractéristiques du signal à courant haute fréquence, chaque commande et/ou combinaison de commandes simultanées correspondant à un ensemble particulier de caractéristiques du signal à courant haute fréquence.
